# EUROPEAN PATENT APPLICATION

(11) **EP 4 106 162 A1**
(43) Date of publication of application: **21.12.2022**
(21) Application number: 21764332.9
(22) Date of filing: 04.02.2021
(51) Int. Cl.: H02M 1/088, H02M 1/32

(54) **DRIVING CIRCUIT OF POWER SWITCHING DEVICE, AND DRIVING SYSTEM**

(30) Priority: 04.03.2020 CN 202010142647
(71) Applicant: Huawei Technologies Co., Ltd., Shenzhen, Guangdong 518129 (CN)
(72) Inventor: HOU, Zhaozheng, Shenzhen, Guangdong 518129 (CN); DONG, Xiaowei, Shenzhen, Guangdong 518129 (CN); QIU, Nengchao, Shenzhen, Guangdong 518129 (CN)
(74) Representative: Maiwald GmbH
(86) International application number: PCT/CN2021/075351
(87) International publication number: WO 2021/175085

(57) **Abstract**

Embodiments of this application disclose a drive circuit of a power device and a drive system, to drive the power device by using a small quantity of components. The drive circuit of the power device includes: a drive signal generation circuit, configured to generate a drive signal; a resistor and a capacitor that are connected in series, coupled to the drive signal generation circuit and the power device, and configured to control turn-on and turn-off of the power device based on the drive signal; and a voltage clamp circuit, coupled to the power device, and configured to control a gate voltage of the power device to be not greater than a gate withstand voltage.

## Description

### CROSS-REFERENCE TO RELATED APPLICATIONS

This application claims priority to Chinese Patent Application No. 202010142647.3, filed with the China National Intellectual Property Administration on March 4, 2020 and entitled "DRIVE CIRCUIT OF POWER DEVICE AND DRIVE SYSTEM", which is incorporated herein by reference in its entirety.

### TECHNICAL FIELD

This application relates to the field of semiconductor technologies, and in particular, to a drive circuit of a power device and a drive system.

### BACKGROUND

A power device is a triode having good turn-on and turn-off characteristics under a specific condition. A control signal is applied to a control end (for example, a gate) of the power device, to turn on and turn off the power device. The power device is widely used in various types of circuits. Specifically, the power device includes but is not limited to a metal-oxide-semiconductor field-effect transistor (metal-oxide-semiconductor field-effect transistor, MOSFET), a gallium nitride (gallium nitride, GaN) transistor, an insulated gate bipolar transistor (insulated gate bipolar transist, IGBT), or a bipolar junction transistor (bipolar junction transistor, BJT).

When the power device is driven, turn-on and turn-off of the power device may be implemented by changing a voltage of the control end of the power device. For example, for the MOSFET and the GaN transistor, when a difference between a gate voltage and a source voltage is greater than or equal to a voltage threshold, the power device is turned on; or when a difference between a gate voltage and a source voltage is less than a voltage threshold, the power device is turned off. In actual application, turn-on and turn-off of the power device may be controlled by applying different voltages to a gate of the power device.

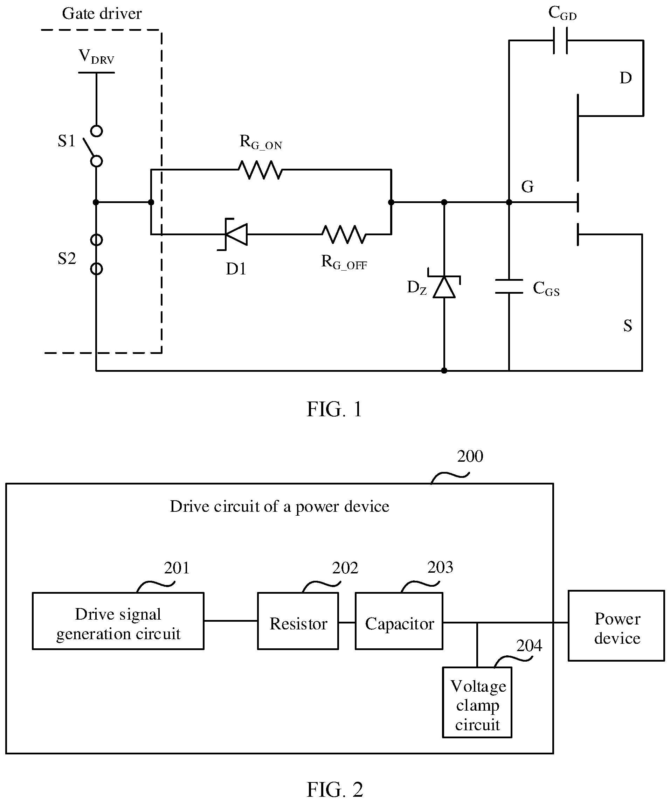

For example, FIG. 1 shows a driving solution of a voltage-type switching device such as a MOSFET and a GaN transistor provided in a conventional technology. In FIG. 1, a gate driver is configured to generate a drive signal, where the drive signal may be at a high level or a low level. The gate driver includes a power supply V_{DRV}, a switch S1, and a switch S2, where the S1 and the S2 are alternately turned on to generate a high level or a low level. The drive circuit includes a R_{G_ON}, a R_{G_OFF}, a D 1, and a D_{Z}. When the drive signal is at a high level, a gate source capacitor C_{GS} in the power device is charged by using the R_{G_ON}, a gate voltage reaches a turn-on voltage, and the power device is turned on. When the drive signal is at a low level, the C_{GS} discharges by using the D1 and the R_{G_OF}, a gate voltage is less than a turn-on voltage, and the power device is turned off. In addition, the Zener diode D_{Z} may clamp the gate voltage, so that the gate voltage is less than a gate withstand voltage.

It is not difficult to learn that in the driving solution shown in FIG. 1, paths of a charging loop and a discharging loop of the C_{GS} are different, and the drive circuit includes a large quantity of components.

### SUMMARY

Embodiments of this application provide a drive circuit of a power device and a drive system, to drive the power device by using a small quantity of components.

According to a first aspect, an embodiment of this application provides a drive circuit of a power device, where the drive circuit includes a drive signal generation circuit, and a resistor and a capacitor that are connected in series, and further includes a voltage clamp circuit. The drive signal generation circuit is configured to generate a drive signal. The resistor and the capacitor that are connected in series are coupled to the drive signal generation circuit and the power device, and are configured to control turn-on and turn-off of the power device based on the drive signal. The voltage clamp circuit is coupled to the power device, and is configured to control a gate voltage of the power device to be not greater than a gate withstand voltage.

The power device is a voltage-type switch device such as a gallium nitride GaN power transistor or a metal-oxide-semiconductor field-effect transistor MOSFET.

According to the drive circuit provided in the first aspect, a gate-source capacitor of the power device may be charged by using the resistor and the capacitor that are connected in series, to turn on the power device. Alternatively, the gate-source capacitor of the power device may be discharged by using the resistor and the capacitor that are connected in series, to turn off the power device. In addition, the voltage clamp circuit may prevent the power device from bearing large current impact in a turn-on process or a turn-off process of the power device. Therefore, reliability of the turn-on process and the turn-off process of the power device is improved. The drive circuit has a simple structure and includes a small quantity of components. Therefore, according to the drive circuit provided in the first aspect, a peripheral drive circuit of the power device is simplified, and the power device is driven by using a small quantity of components. Therefore, a board area occupied by the drive circuit is reduced, and power density is improved.

In a possible design, the resistor and the capacitor that are connected in series are specifically configured to: when the drive signal is at a high level, control the power device to be turned on; or when the drive signal is at a low level, control the power device to be turned off.

In other words, when the drive signal is at a high level, a gate-source capacitor of the power device may be charged by using the resistor and the capacitor that are connected in series, to turn on the power device. When the drive signal is at a low level, the gate-source capacitor of the power device may be discharged by using the resistor and the capacitor that are connected in series, to turn off the power device.

In the drive circuit provided in the first aspect, a first end of the resistor is coupled to the drive signal generation circuit, a second end of the resistor is coupled to a first end of the capacitor, and a second end of the capacitor is coupled to a gate of the power device. Alternatively, a first end of the capacitor is coupled to the drive signal generation circuit, a second end of the capacitor is coupled to a first end of the resistor, and a second end of the resistor is coupled to a gate of the power device.

In other words, for the resistor and the capacitor that are connected in series, one end of the resistor and the capacitor is coupled to the drive signal generation circuit, and the other end of the resistor and the capacitor is coupled to the gate of the power device. However, a sequence of connecting the resistor and the capacitor in series is not limited.

In a possible design, the voltage clamp circuit includes a Zener diode. A cathode of the Zener diode is coupled to the gate of the power device, an anode of the Zener diode is coupled to a source of the power device, and a Zener breakdown voltage of the Zener diode is less than or equal to the gate withstand voltage.

According to the foregoing solution, the gate voltage of the power device can be stabilized at a value less than or equal to the gate withstand voltage by using the Zener diode. Therefore, reliability of the power device is improved.

In another possible design, the voltage clamp circuit includes an electrostatic discharge ESD circuit. In addition to controlling the gate voltage of the power device to be not greater than the gate withstand voltage, the ESD circuit is further configured to discharge static electricity when the static electricity is generated between the gate and a source of the power device.

According to the foregoing solution, the ESD circuit may be used to stabilize the gate voltage of the power device at a value less than or equal to the gate withstand voltage. Therefore, reliability of the power device is improved. In addition, the ESD circuit further has an electrostatic discharge function. The ESD circuit is used to discharge static electricity and control the gate voltage of the power device, so that a peripheral circuit of the power device is further simplified, parasitic parameters of the drive circuit are reduced, and signal quality is improved.

In a possible design, the drive signal generation circuit includes a direct current voltage source, a first switch, and a second switch. A first end of the first switch is coupled to the direct current voltage source, a second end of the first switch is coupled to a second end of the second switch, and a second end of the second switch is coupled to a ground end. The first switch and the second switch are alternately turned off, and the first end of the first switch is configured to output the drive signal.

According to the foregoing solution, when the first switch is turned off, and the second switch is turned on, the drive signal generation circuit outputs a high level. When the first switch is turned on, and the second switch is turned off, the drive signal generation circuit outputs a low level. In this way, a function of the drive signal generation circuit is implemented.

According to a second aspect, an embodiment of this application provides a drive system, where the drive system includes the drive circuit and the power device provided in any one of the first aspect and the possible designs of the first aspect, and the drive circuit is configured to drive the power device.

In addition, for technical effects brought by any possible design manner in the second aspect, refer to technical effects brought by different design manners in the first aspect. Details are not described herein again.

### BRIEF DESCRIPTION OF DRAWINGS

FIG. 1 is a schematic diagram of a structure of a drive circuit in a conventional technology;
FIG. 2 is a schematic diagram of a structure of a first drive circuit of a power device according to an embodiment of this application;
FIG. 3 is a schematic diagram of a structure of an electrostatic discharge circuit according to an embodiment of this application;
FIG. 4 is a schematic diagram of a structure of a second drive circuit of a power device according to an embodiment of this application;
FIG. 5 is a schematic diagram of a structure of a third drive circuit of a power device according to an embodiment of this application; and
FIG. 6 is a schematic diagram of a structure of a drive system according to an embodiment of this application.

### DESCRIPTION OF EMBODIMENTS

Embodiments of this application provide a drive circuit of a power device and a drive system, to drive the power device by using a small quantity of components.

The following specifically describes a driving solution of the power device provided in embodiments of this application with reference to the accompanying drawings.

It should be noted that "a plurality of' used in this application means two or more. In addition, it should be understood that in the description of this application, terms such as "first" and "second" are merely used for distinguishing and description, and cannot be understood as an indication or implication of relative importance or an indication or implication of an order.

FIG. 2 is a schematic diagram of a structure of a drive circuit of a power device according to an embodiment of this application. A drive circuit 200 of the power device (which is referred to as a "drive circuit 200" hereinafter) includes a drive signal generation circuit 201, a resistor 202 and a capacitor 203 that are connected in series, and a voltage clamp circuit 204.

The drive signal generation circuit 201 is configured to generate a drive signal. The resistor 202 and the capacitor 203 that are connected in series are coupled to the drive signal generation circuit 201 and the power device, and are configured to control turn-on and turn-off of the power device based on the drive signal. The voltage clamp circuit 204 is coupled to the power device, and is configured to control a gate voltage of the power device to be not greater than a gate withstand voltage.

The power device may be a MOSFET or a GaN transistor, or may be another voltage-type switching device. A GaN material has a low heat generation rate and a high breakdown electric field, and can be used to manufacture the field effect transistor. Due to a limitation of a gate process, a driving range of the GaN transistor is narrow, that is, a difference between a turn-on voltage and an upper limit of a withstand voltage of the GaN transistor is small. For example, a gate withstand voltage of the MOSFET is -20 V to 20 V, and a gate withstand voltage of the GaN transistor is -10 V to 7 V A turn-on voltage of the transistor is usually 6 V. Therefore, for the GaN transistor, when a gate voltage is equal to 6 V, the GaN transistor is conducted. However, provided that the gate voltage is increased by 1 V, a gate withstand voltage of the GaN transistor is exceeded. This causes breakdown of the GaN transistor. However, there is still a margin of 14 V between the gate withstand voltage and the turn-on voltage of the MOSFET. Therefore, the GaN transistor has a weaker anti-interference capability than the MOSFET, and has a higher requirement on the drive circuit.

In the drive circuit 200, a first end of the resistor 202 is coupled to the drive signal generation circuit 201, a second end of the resistor 202 is coupled to a first end of the capacitor 203, and a second end of the capacitor 203 is coupled to a gate of the power device (a connection manner is used as an example in FIG. 2). Alternatively, a first end of the capacitor 203 is coupled to the drive signal generation circuit 201, a second end of the capacitor 203 is coupled to a first end of the resistor 202, and a second end of the resistor 202 is coupled to a gate of the power device.

In other words, for the resistor 202 and the capacitor 203 that are connected in series, one end of the resistor 202 and the capacitor 203 is coupled to the drive signal generation circuit 201, and the other end of the resistor 202 and the capacitor 203 is coupled to the gate of the power device. A sequence of connecting the resistor 202 and the capacitor 203 in series is not limited in this embodiment of this application. In other words, locations of the resistor 202 and the capacitor 203 may be exchanged. FIG. 2 is shown by using an example in which the resistor 202 is coupled to the drive signal generation circuit 201 and the capacitor 203 is coupled to the power device. In actual application, a connection manner in which the capacitor 203 is coupled to the drive signal generation circuit 201 and the resistor 202 is coupled to the power device may also be used.

Specifically, in this embodiment of this application, the resistor 202 and the capacitor 203 that are connected in series are specifically configured to: when the drive signal is at a high level, charge a gate-source capacitor in the power device, to control the power device to be turned on; or when the drive signal is at a low level, discharge the gate-source capacitor in the power device, to control the power device to be turned off.

Certainly, a high level and a low level of the drive signal are relative to a same reference ground. When different reference grounds are used, a "low level" described in this application may also be a valid level.

In addition, it should be understood that the gate-source capacitor is a capacitor bridged between the gate and the source inside the power device. In this embodiment of this application, the resistor 202 and the capacitor 203 that are connected in series are configured to charge and discharge the gate-source capacitor. When the gate-source capacitor is charged, a voltage between the gate and the source increases, and when the gate voltage reaches a turn-on voltage of the power device, the power device is turned on. When the gate-source capacitor is discharged, a voltage between the gate and the source decreases, and when the gate voltage is less than a turn-on voltage of the power device, the power device is turned off.

In addition, in the drive circuit 200, the drive signal generation circuit 201 may include a direct current voltage source, a first switch, and a second switch. A first end of the first switch is coupled to the direct current voltage source, a second end of the first switch is coupled to a second end of the second switch, and a second end of the second switch is coupled to a ground end. The first switch and the second switch are alternately turned off, and the first end of the first switch is configured to output the drive signal.

By using the foregoing drive signal generation circuit 201, when the first switch is turned on, and the second switch is turned off, the drive signal generation circuit 201 outputs a high level. When the first switch is turned off, and the second switch is turned on, the drive signal generation circuit 201 outputs a low level. Specific types of the first switch and the second switch are not limited in this embodiment of this application. For example, the first switch and the second switch may be common single-pole single-throw switches, or may be controllable switches such as transistors.

Certainly, a structure of the drive signal generation circuit 201 is merely an example. In actual application, the drive signal generation circuit 201 may have a plurality of structures, provided that the drive signal generation circuit 201 can output a drive signal having a high level or a low level.

According to the drive circuit 200 provided in this embodiment of this application, the gate-source capacitor may be charged by using the resistor 202 and the capacitor 203 that are connected in series, to turn on the power device. Alternatively, the gate-source capacitor may be discharged by using the resistor 202 and the capacitor 203 that are connected in series, to turn off the power device. In addition, the voltage clamp circuit 204 may prevent the power device from bearing large current impact in a turn-on process or a turn-off process of the power device. Therefore, reliability of the turn-on process and the turn-off process of the power device is improved. The drive circuit 200 has a simple structure and includes a small quantity of components. Therefore, the power device may be driven by using the small quantity of components.

In addition, in a scenario in which the power device needs to be turned on, the drive signal generation circuit 201 may output a high level, and the resistor 202 and the capacitor 203 that are connected in series charge the gate-source capacitor, so that the gate voltage is greater than the turn-on voltage, and the power device is turned on. In a scenario in which the power device needs to be turned off, the drive signal generation circuit 201 may output a low level. When output of the drive signal generation circuit 201 jumps from a high level to a low level, because a voltage on the capacitor 203 cannot suddenly change, the gate voltage of the power device suddenly changes to a negative value. Therefore, negative gate driving (that is, the power device is turned off by applying a negative voltage to the gate) is implemented. In comparison with a solution in a conventional technology in which a power device can be turned off only by using a positive voltage driving solution, using the drive circuit 200 provided in this embodiment of this application has a better turn-off effect of the power device.

FIG. 1 is used as an example. When the drive signal is at a high level, a current flows from a left side of the capacitor 203 to a right side, and a voltage on the left side of the capacitor 203 is greater than a voltage on the right side of the capacitor 203. When the drive signal jumps to a low level, a current flows from the right side of the capacitor 203 to the left side. Because the voltage on the capacitor 203 does not suddenly change, the voltage on the left side of the capacitor 203 is still greater than the voltage on the right side of the capacitor 203. In this case, because the left side of the capacitor 203 is at a low level, the voltage on the right side of the capacitor 203 is transiently pulled to a negative voltage. In other words, the gate voltage of the power device changes to a negative voltage. Therefore, negative gate driving is implemented.

Specifically, the voltage clamp circuit 204 may include a Zener diode, where a cathode of the Zener diode is coupled to the gate of the power device, an anode of the Zener diode is coupled to a source of the power device, and a Zener breakdown voltage of the Zener diode is less than or equal to a gate withstand voltage of the power device. The Zener diode is used, and the gate voltage of the power device may not be greater than the gate withstand voltage. Therefore, reliability of the power device is improved.

For example, the gate withstand voltage of the power device is 7 V, and the source of the power device is grounded. In this case, a Zener diode with a Zener breakdown voltage of 6.2 V may be selected, to ensure that when the drive signal is at a high level, the gate voltage of the power device is not greater than 7 V.

In application of a power device, electrostatic discharge (electro-static discharge, ESD) is highly likely to cause damage to the power device. When static electricity is generated, a gate (for example, a gate) of the power device generates a large current transiently. This causes damage to the power device. In the conventional technology, an ESD circuit is generally disposed inside a power device, and the ESD circuit may discharge a large current generated by static electricity when ESD is generated, to protect the power device.

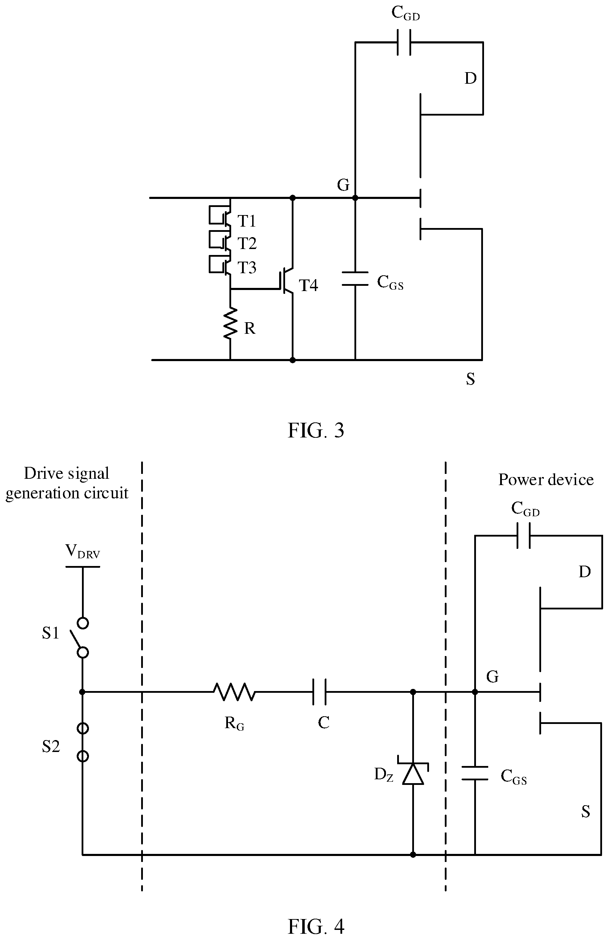

For example, FIG. 3 is a schematic diagram of a structure of an ESD circuit. The ESD circuit bridges between the gate and the source of the power device, and includes transistors T1, T2, T3, and T4 and a resistor R. When static electricity is generated between the gate and the source of the power device, a large current flows between the gate and the source, and a gate voltage suddenly increases. In this case, the transistors T1, T2, and T3 are all turned on, and a voltage is applied to the resistor R, so that a gate voltage of the transistor T4 reaches a turn-on voltage of the transistor T4, and the transistor T4 is turned on. In addition, a current generated between the gate and the source due to static electricity is discharged by using the transistor T4. Therefore, a function of electrostatic discharge is implemented.

In this embodiment of this application, the voltage clamp circuit 204 may include an ESD circuit. In addition to controlling the gate voltage of the power device to be not greater than the gate withstand voltage, the ESD circuit is further configured to discharge static electricity when the static electricity is generated between the gate and the source of the power device. The ESD circuit may use a plurality of manners to protect electrostatic discharge. For example, the ESD circuit may protect electrostatic discharge in a forward direction, a reverse direction, and a forwardreverse direction. For a specific structure of the ESD circuit, refer to the conventional technology. Details are not described herein.

In other words, the ESD circuit may be disposed in the drive circuit 200. In this way, the ESD circuit may not be disposed in the power device. The ESD circuit in the drive circuit 200 can not only implement a voltage regulation function of the voltage clamp circuit 204, but also implement an ESD protection function. According to the foregoing solution, the ESD protection function can be implemented on a premise that a small quantity of components are added. Therefore, a peripheral circuit of the power device is further simplified, parasitic parameters of the drive circuit 200 are reduced, and signal quality is improved.

In conclusion, according to the drive circuit 200 provided in this embodiment of this application, the gate-source capacitor of the power device may be charged by using the resistor 202 and the capacitor 203 that are connected in series, to turn on the power device. Alternatively, the gate-source capacitor may be discharged by using the resistor 202 and the capacitor 203 that are connected in series, to turn off the power device. In addition, the voltage clamp circuit 204 may prevent the power device from bearing large current impact in a turn-on process or a turn-off process of the power device. Therefore, reliability of the turn-on process and the turn-off process of the power device is improved. The drive circuit 200 has a simple structure and includes a small quantity of components. Therefore, according to the drive circuit 200 provided in this embodiment of this application, a peripheral drive circuit of the power device is simplified, and the power device is driven by using a small quantity of components. Therefore, a board area occupied by the drive circuit 200 is reduced, and power density is improved.

For example, FIG. 4 is a schematic diagram of a structure of a drive circuit of a power device according to this application. The drive circuit of the power device may be considered as a specific example of the drive circuit 200. As shown in FIG. 4, the drive circuit includes a drive signal generation circuit, a resistor R_{G}, a capacitor C, and a Zener diode Dz. The drive signal generation circuit includes a power supply V_{DRV}, a switch S1, and a switch S2, where the S1 and the S2 are alternately turned off to generate a high level or a low level.

When the drive signal is at a high level, the drive current charges the C_{GS} by using the R_{G} and the C. In addition, the Dz may clamp a highest voltage on a gate to ensure that a gate voltage does not exceed a gate withstand voltage of 7 V When the drive signal is at a low level, a voltage on the C_{GS} is discharged to a ground by using the R_{G} and the C. Because the voltage on the capacitor C cannot change suddenly, negative gate driving of the gate may be implemented by using the capacitor C, and the Dz may clamp a negative voltage on the gate.

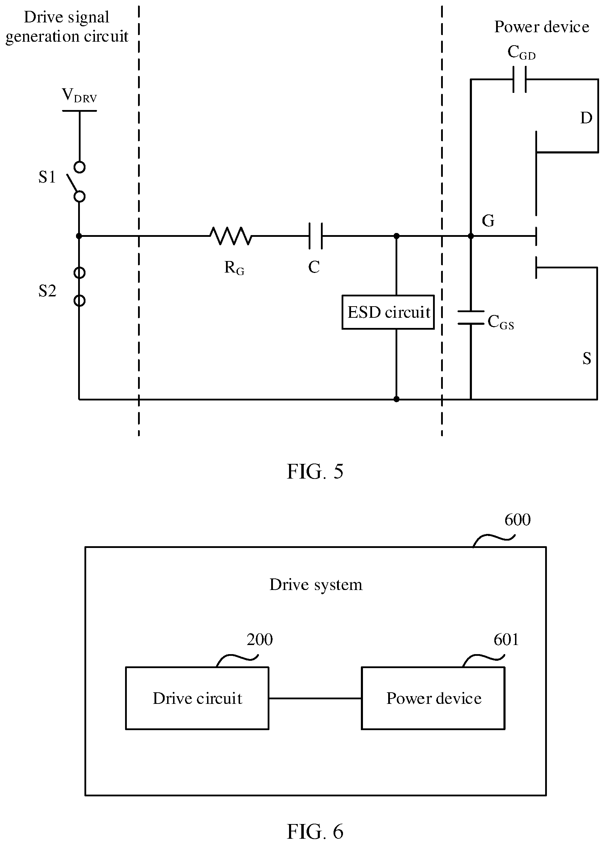

For example, FIG. 5 is a schematic diagram of a structure of a drive circuit of a power device according to this application. The drive circuit of the power device may be considered as a specific example of the drive circuit 200. As shown in FIG. 5, the drive circuit includes a drive signal generation circuit, a resistor R_{G}, a capacitor C, and an ESD circuit. The drive signal generation circuit includes a power supply V_{DRV}, a switch S1, and a switch S2, where the S1 and the S2 are alternately turned off to generate a high level or a low level. The ESD circuit is configured to: control a gate voltage of the power device to be not greater than a gate withstand voltage, and discharge static electricity when the static electricity is generated between a gate and a source of the power device.

When the drive signal is at a high level, the drive current charges the C_{GS} by using the R_{G} and the C. In addition, the ESD circuit can clamp a highest voltage on the gate to ensure that the gate voltage does not exceed a gate withstand voltage of 7 V. When the drive signal is at a low level, a voltage on the C_{GS} is discharged to a ground by using the R_{G} and the C. Because the voltage on the capacitor C cannot change suddenly, negative gate driving of the gate may be implemented by using the capacitor C, and the ESD circuit may clamp a negative voltage on the gate. In addition, the ESD circuit may further discharge static electricity when the static electricity is generated between the gate and the source of the power device.

It should be noted that the drive circuits shown in FIG. 4 and FIG. 5 are merely specific examples of the drive circuit 200. For implementations and technical effects that are not described in detail in the drive circuits shown in FIG. 4 and FIG. 5, refer to related description of the drive circuit 200. Details are not described herein again.

Based on a same inventive concept, an embodiment of this application further provides a drive system. Refer to FIG. 6. A drive system 600 includes the foregoing drive circuit 200 and a power device 601. The drive circuit 200 is configured to drive the power device 601.

The power device 601 may be a MOSFET, or may be a GaN transistor. For a structure and a function of the drive circuit 200, refer to the foregoing description. Details are not described herein again.

It is clear that a person skilled in the art can make various modifications and variations to this application without departing from the scope of this application. This application is intended to cover these modifications and variations of this application provided that they fall within the scope of protection defined by the following claims and their equivalent technologies.

## Claims

1. A drive circuit of a power device, comprising:
a drive signal generation circuit, configured to generate a drive signal;
a resistor and a capacitor that are connected in series, coupled to the drive signal generation circuit and the power device, and configured to control turn-on and turn-off of the power device based on the drive signal; and
a voltage clamp circuit, coupled to the power device, and configured to control a gate voltage of the power device to be not greater than a gate withstand voltage.

2. The drive circuit according to claim 1, wherein the resistor and the capacitor that are connected in series are specifically configured to:
when the drive signal is at a high level, control the power device to be turned on, and when the drive signal is at a low level, control the power device to be turned off.

3. The drive circuit according to claim 1 or 2, wherein a first end of the resistor is coupled to the drive signal generation circuit, a second end of the resistor is coupled to a first end of the capacitor, and a second end of the capacitor is coupled to a gate of the power device; or a first end of the capacitor is coupled to the drive signal generation circuit, a second end of the capacitor is coupled to a first end of the resistor, and a second end of the resistor is coupled to a gate of the power device.

4. The drive circuit according to any one of claims 1 to 3, wherein the voltage clamp circuit comprises:
a Zener diode, wherein a cathode of the Zener diode is coupled to the gate of the power device, an anode of the Zener diode is coupled to a source of the power device, and a Zener breakdown voltage of the Zener diode is less than or equal to the gate withstand voltage.

5. The drive circuit according to any one of claims 1 to 3, wherein the voltage clamp circuit comprises:
an electrostatic discharge ESD circuit, wherein the ESD circuit is further configured to discharge static electricity when the static electricity is generated between the gate and a source of the power device.

6. The drive circuit according to any one of claims 1 to 5, wherein the drive signal generation circuit comprises a direct current voltage source, a first switch, and a second switch, wherein a first end of the first switch is coupled to the direct current voltage source, a second end of the first switch is coupled to a second end of the second switch, and a second end of the second switch is coupled to a ground end; and the first switch and the second switch are alternately turned off, and the first end of the first switch is configured to output the drive signal.

7. The drive circuit according to any one of claims 1 to 6, wherein the power device is a gallium nitride GaN power transistor or a metal-oxide-semiconductor field-effect transistor MOSFET.

8. A drive system, comprising:
the drive circuit and the power device according to any one of claims 1 to 7, wherein the drive circuit is configured to drive the power device.
